(19) Europäisches Patentamt
European Patent Office
Office européen des brevets

(11) EP 1 147 598 B1

(12) **EUROPEAN PATENT SPECIFICATION**

(45) Date of publication and mention of the grant of the patent:
**06.05.2004 Bulletin 2004/19**

(21) Application number: **99960616.3**

(22) Date of filing: **30.11.1999**

(51) Int Cl.$^7$: **H03D 7/16**

(86) International application number:
**PCT/US1999/028232**

(87) International publication number:
**WO 2000/033457 (08.06.2000 Gazette 2000/23)**

# (54) UNIVERSAL MODULATOR

UNIVERSALMODULATOR

MODULATEUR UNIVERSEL

(84) Designated Contracting States:
**AT BE CH CY DE DK ES FI FR GB GR IE IT LI LU MC NL PT SE**

(30) Priority: **30.11.1998 US 110254 P**

(43) Date of publication of application:
**24.10.2001 Bulletin 2001/43**

(73) Proprietor: **General Instrument Corporation**
**Horsham, Pennsylvania 19044 (US)**

(72) Inventors:
- **WAIGHT, Matthew, G.**
**Pipersville, PA 18947 (US)**
- **PATEL, Dipakkumar, R.**
**Hatboro, PA 19040 (US)**

(74) Representative: **Cooper, John et al**
**Murgitroyd & Company**
**165-169 Scotland Street**
**Glasgow G5 8PL (GB)**

(56) References cited:
**WO-A-84/04637**
**WO-A-97/23034**
**DE-A- 4 306 578**
**US-A- 5 038 404**
**US-A- 5 640 697**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 147 598 B1

## Description

## BACKGROUND

The present invention generally relates to cable television (CATV) and consumer video communication systems. More particularly, the invention relates to a dual-conversion universal modulator having programmable synthesized phase-locked loop oscillators driving their respective mixers which select a specific HI-IF frequency depending upon what output frequencies or standards are desired. Such standards include NTSC, PAL, NICAM, DIN, SECAM and any other known standard.

To allow reception of more than the 12 VHF channels on an older television receiver, most CATV systems require a settop terminal at a subscriber's location. Today, settop terminals not only provide a means for accepting a plurality of channels broadcast with varying bandwidths and guardbands for forward and reverse frequencies, but they also secure pay television services from unauthorized viewing. Other functions include decoding digital video and audio, interactive services, creating personalized viewer channels and the like.

In addition to the conversion from a cable transmission to a standard output frequency, a variety of descrambling techniques are employed depending upon the techniques used at a system headend. CATV equipment manufacturers are developing more sophisticated scrambling techniques using complicated encryption methods and digital processing to thwart pirating.

Most settop terminals are tunable. A block diagram for a prior art settop terminal is shown in Figure 1. Incoming signals from a CATV transmission network are coupled to an input bandpass amplifier and up-converted to a high intermediate frequency (HI-IF). The up-conversion requires a tunable local oscillator which selects a desired channel and an associated mixer. The mixer is coupled to a bandpass filter and down-converted to an IF channel using a fixed-frequency local oscillator and mixer. The output channel is filtered and forwarded to a subscriber's television receiver. Prior art settop terminals use one down-converter mixer with an oscillator having slight frequency agility to provide an output at one or two preselected channel frequencies. The output frequencies and bandwidths depend upon the transmission standard used.

In the United States, the NTSC (National Television System Committee) is the standard for color television. Other countries have chosen different systems. SECAM (*sequentiel couleur avec mémoire*) is used by France and Russia. PAL A and PAL B (phase alternation line) are used by many European countries such as Germany and the United Kingdom. Accordingly, television receivers are typically manufactured for a specific transmission standard. For worldwide use, a settop terminal must be adapted to the established broadcast standards.

U.S. Patent No. 5,640,697 teaches the use of two predetermined frequencies for each local oscillator, whereby the second oscillator frequency can be adjusted independently of the first oscillator frequency. Adjustment between the two frequencies is used to adapt to the different output frequencies, while eliminating noise caused by the local oscillators. Similar to U.S. Patent No. 5,640,497, German Patent No. Application 4,306,578 adjusts the oscillator frequencies by a predetermined amount in order to eliminate noise. PCT International Patent Application No. 84/04637 employs two local oscillators that generate predetermined frequencies, in which the second oscillator is selected between one of two frequencies to eliminate this noise.

Accordingly, there exists a need for an inexpensive method to adapt the output of a settop terminal to a variety of television broadcast standards.

## SUMMARY

The present invention is a universal modulator that accepts baseband audio and video inputs and modulated audio or data and converts the combined signal to one of a plurality of frequencies in dependence upon a desired output frequency and broadcast standard. The universal modulator is located between baseband video and audio outputs of a settop terminal demodulator/decoder and an antenna input of a television receiver or other audio/video component (such as a VCR). The universal modulator includes a dual conversion architecture using an up-converter mixer and a down-converter mixer. Each mixer receives an oscillator input from a corresponding addressable, programmable, PLL (phase-locked loop) frequency synthesizer. Each PLL frequency is controlled by firmware in the settop terminal. Configuration is performed via manual input using settop terminal controls, or interrogation directly by the CATV headend or by programmed settings. A communication bus coupled to the firmware distributes addressable instructions to selectively control each PLL frequency and obviate oscillator difference beat frequencies (ODBFs) that may be manifested.

Accordingly, it is an object of the present invention to provide a universal modulator within a settop terminal which is able to couple a CATV transmission network to a customer's television receiver notwithstanding the broadcast standard used to transmit the television programs.

Other objects and advantages will become apparent to those skilled in this art after reading the detailed description of the preferred embodiment.

## BRIEF DESCRIPTION OF THE DRAWINGS

**Figure 1** is a block diagram of a prior art CATV settop terminal.
**Figure 2** is a block diagram of a settop terminal incorporating the present invention.
**Figure 3** is a block diagram of the preferred embodiment of the universal modulator of the present invention for use in a settop terminal.
**Figure 4** is a block diagram of an addressable, programmable, phase-locked loop.
**Figure 5** is a flow chart of the universal modulator configuring process.
**Figure 6** is a flow chart of the ODBF translation process.
**Figure 7** is a block diagram of a prior art headend.
**Figure 8** is a block diagram of a headend made in accordance with the present invention.
**Figures 9A and 9B** are graphs of oscillator difference beat frequencies.

## DETAILED DESCRIPTION OF THE PREFERRED EMBODIMENTS

The preferred embodiment will be described with reference to the drawing figures where like numerals represent like elements throughout.

**Figure 2** is a block diagram of a settop terminal **17** with the universal modulator **19** shown coupled to the output of a demodulator/decoder **21.** The demodulator/decoder **21** outputs a customer's channel selection as baseband audio **23** and video **25.** The functional description of the demodulator/decoder **21** is beyond the scope of the present invention **19** and shall not be described. An alternate audio source **27**, such as a NICAM carrier or modulated audio, may also be supplied and output **29**.

The higher quality baseband audio **23** and video **25** signals are available as settop terminal outputs **31, 33** and may be coupled to television receivers that have baseband inputs. For television receivers that lack this feature, the universal modulator **19** provides an up-conversion output **35** compatible with the television broadcast standard used, from baseband to VHF or UHF for coupling to an antenna input.

The demodulator/decoder **17** outputs baseband audio **23** and video **25** and an alternate audio carrier **27** which differs from the baseband audio output. A reference clock signal **37** originating from a master oscillator and a common communication bus **39** are also coupled to the modulator **19**.

The universal modulator **19** is shown in more detail in **Figure 3**. The common communication bus **39** shown is an $I^2C$ interface from Phillips® Electronics. Other bus communication protocols may alternatively be used. The configuration for a settop terminal **17** may be downloaded from the CATV system headend via a dedicated channel, or inband on the VBI of a channel. One skilled in this art would appreciate that an advanced cable system can address and interrogate a specific settop terminal and alter its functionality. If the settop terminal has all configurations stored in firmware, the CATV system headend may simply instruct the settop terminal **17** of the standard being used. In this fashion, the settop terminal **17** does not require a technician to configure the unit but can auto-configure upon initial energization.

The communication bus protocol permits configuring component parameters to a particular broadcast standard using a unique addressing system within the settop terminal **17**. As shown in **Figure 3**, the $I^2C$ bus **39** communicates with: a baseband audio programmable PLL frequency synthesizer **41**, a second audio carrier switched input **43,** adjustable amplifiers for the baseband video input **45** and baseband audio input **47**, a programmable PLL frequency synthesizer **49** for an up-converter mixer **91** and a programmable PLL frequency synthesizer **51** for a down-converter mixer **101**. Although third addressable programmable PLL **51** has been described as being coupled to a "down-converter" mixer **101**, the down-converter mixer **101** may in fact further up-convert the HI-IF signal to a higher frequency signal. It should be noted that each PLL frequency synthesizer **41**, **49**, **51** has an associated oscillator driver **L01**, **L02**, **L03** respectively (not shown). Each respective component has its own address to permit firmware contained parameters to be loaded for a given broadcast standard configuration.

The alternate audio input **53,** modulated by the demodulator/decoder **21**, is coupled to the solid state switch **43.** The output of the switch **43** is coupled to a first input **55** of a summing amplifier **57**. The baseband video input **59** is coupled to a clamp **61** which limits signal amplitude. The output from the clamp **61** is coupled to the video adjustable amplifier **45** where signal gain is increased or attenuated depending upon the broadcast standard. The output from the adjustable amplifier **45** is coupled to a hard limiter **63** which clips signal peaks. The output from the limiter **63** is coupled to a second input **65** of the summing amplifier **57.** The baseband audio input **67** is coupled to a baseband audio mixer **69** via an adjustable amplifier **68**. The baseband audio mixer **69** modulates the baseband to the broadcast standard. The baseband audio mixer **69** may be selectively activated or deactivated by the $I^2C$ bus as required to support the standard in use. The output from the baseband audio mixer **69** is coupled to a lowpass filter **71** to remove RF. A second input to the audio lowpass filter **71** is provided as a modulated audio input **72.** The audio lowpass filter **71** is coupled to an audio adjustable amplifier **47** where signal gain is increased or attenuated. The audio adjustable amplifier **47** output is coupled to a third input **73** of the summing amplifier **57.**

Each of the mixers mix a signal input with the outputs of the three addressable, programmable PLL frequency synthesizers **41, 49, 51**. The PLL output frequencies vary depending on the broadcast standard and the RF output frequency **105** desired. An addressable, programmable PLL frequency synthesizer **41**, **49**, **51** is shown in **Figure 4**.

The PLL **41, 49, 51** includes a phase detector **75,** a voltage-controlled oscillator (VCO) **77** and a loop filter **79**. The programmable PLL uses digital and analog techniques for frequency synthesis. The phase detector **75** compares two input frequencies **81a**, **81b** and generates an output **83** that is a measure of their phase difference. If both inputs **81a, 81b** differ in frequency, the output is periodic at the difference frequency. If the frequency input does not equal the frequency output of the VCO **77**, the phase-error signal, after being filtered, causes the VCO frequency to deviate in the direction of the input frequency. When the frequencies match, the VCO **77** locks to the input frequency maintaining a fixed phase relationship with the input signal. The filtered output of the phase detector **75** is a dc signal. A modulo-n counter **87** is coupled between the VCO **77** output and the second input **81a** to the phase detector **75** to generate a multiple of the input reference frequency providing frequency synthesis.

Each PLL synthesizer **41, 49, 51** employed in the present invention **19** is addressable such that the input frequency can be adjusted by using an input modulo-*n* counter **89** or divide-by-*n* to adjust output frequency. Both the input frequency divide-by-*n* **89** and loop frequency divide-by-*n* **87** are addressable components. Each of the PLLs **41**, **49**, **51** are addressed and controlled in accordance with a predetermined settop terminal **17** configuration. The configuration determines both the output frequency and operating bandwidth of the settop terminal **17** and adjusts the up- and down-converter PLLs **49, 51** accordingly.

Referring back to **Figure 3**, the summer amplifier **57** output is modulated with the frequency output from the second programmable PLL **49** to drive the up-conversion modulator **91** and translate the summed output to a high intermediate frequency (HI-IF) **93**. The HI-IF **93** is higher than the highest expected frequency in the summed amplifier **57** output bandwidth. In the present invention **19**, the input to the up-converter mixer **91** is not bandwidth limited.

The summing amplifier **57** output frequencies are translated to a new bandwidth, starting at a low frequency of the second PLL **49** minus the highest input band frequency, and ending at a high frequency of the third PLL **51** minus the lowest input band frequency. The second PLL **49** frequency is selected to translate the summing amplifier **57** output to correspond to the passband of an intermediate lowpass filter **95**. The output from the lowpass filter **95** is coupled to a buffer amplifier **97** to restore gain losses. The output from the buffer amplifier **97** is input to a final lowpass filter **99.** The buffer amplifier **97** maintains the system noise figure by overcoming the losses in the up-conversion mixer **91** and first HI-IF filter **95.** The signal is filtered by a HI-FI filter **99**, with the output coupled to a down-conversion mixer **101.** The third PLL synthesizer **51** is coupled to the down-conversion mixer **101.** The difference between the HI-IF **93** and the third PLL **51** frequency is the desired output channel in the IF band. It should, however, be noted that the down-converter mixer **101** may accept the HI-IF **93** and further up-convert the signal to a higher frequency RF signal. The output is then filtered via a low pass filter **103,** (or other appropriate filter if up-converted), and forwarded as an RF output frequency **105** for reception by a television receiver.

As discussed above, the second **49** and third **51** programmable PLLs are controlled by the common communication bus **39.** The bus **39** is coupled to a processor in the settop terminal demodulator/decoder **21** which receives instructions from the system headend or from the settop terminal's **17** keypad. The configuration takes place transparently upon initial energization of the unit **17** if the system headend is equipped to send broadcast configuration instructions to the settop terminal **17**. If the system headend does not have this capability, the settop terminal **17** is configured via the keypad and function display (not shown). The configuration request, whether from the headend or at a consumer location, outputs the predetermined parameters onto the $I^2C$ bus **39** for each of the addressable components. The predetermined parameters are related to the standard that is being employed by the CATV system on which the settop terminal **17** is located. These parameters will include the determination of whether a second audio carrier **53** exists, whether the baseband audio input **67** or the modulated audio input **72** are to be used and the frequency at which the RF output frequency **105** is desired. These parameters may also include any other configurable parameters which are employed by any of the addressable components coupled to the communication bus **39.** It should also be recognized that since many of the components are addressable by the communication bus **39,** a user may manually input and address a particular component and selectively configure that component if desired.

An undesirable artifact of dual conversion is the generation of harmonics based on the fundamental oscillator frequencies. The harmonics of the second and third PLL frequency synthesizers **49, 51** mix with each other, thereby creating ODBFs. To obviate the intrusive effects of these PLL harmonics, the system and method of the present invention **19** eliminate this type of interference by translating the significant ODBFs out of the desired output channel.

A flowchart of the preferred method of the present invention **19** is shown in **Figure 5**. Upon making the necessary connections to the CATV cable **15** and subscriber's television receiver, the settop terminal **17** is energized **(step 201)** establishing communication with the system headend. If the cable system headend has forward communication ability **(step 205)**, the settop terminal is instructed how to configure itself for the applicable broadcast standard by downloading the parameters for the regional standards being used and the channel broadcast maps **(step 207).** The predetermined PLL frequencies derived from the channel and broadcast maps in memory are converted into corresponding "divide-by" numbers for the PLL modulo-*n* converters **87, 89** and output to the second **49** and third **51** PLL frequency synthesizers. The settop terminal **17** acknowledges when configuration is complete. If the cable system does not have forward communication capability, the user will be prompted to enter the applicable information via a display and keypad, thereby manually loading the applicable broadcast configuration **(step 209).**

The settop terminal **19** reviews the loaded channel and broadcast maps. The predetermined frequencies are examined for potential ODBFs **(step 211)**. If it is determined that ODBF's are likely **(step 213)**, an ODBF translation is performed **(step 215)** as shown in **Figure 6** (which will be explained in greater detail hereafter). Otherwise, the original frequencies are maintained **(step 217) (Figure 5).** The frequencies are addressed to their respective PLL synthesizers as words over the $I^2C$ communication bus **(step 219)**.

Referring to the flow diagram of **Figure 6**, the elimination of ODBFs is achieved by selectively adjusting the frequencies of the second **49** and third PLLs **51** to obtain the desired RF output frequency. For a typical NTSC signal, the up-converter mixer **91** modulates the input video **59** and audio signals **67** with the output **93** of the second PLL **49** to up-convert the input RF signal of the selected channel to the HI-IF **93 (step 301)**.

$$LO1 = \text{audio carrier frequency} \qquad \text{(Equation 1)}$$

$$LO2 = \text{HI-IF} \qquad \text{(Equation 2)}$$

The down-converter mixer mixes **101** the HI-IF **93** with the output of the third PLL synthesizer **51 (step 303)** to down-convert, (or further up-convert if desired), to obtain the desired RF output frequency **105**.

$$LO3 = (HI - IF) + RF\ output \qquad \text{(Equation 3)}$$

Multiples of the second and third PLL synthesizer **49, 51** fundamental frequencies define the even and odd harmonics,

$$m(LO2)\ and\ m(LO3),\ for\ m = 1, 2, 3, 4, \ldots \infty, \qquad \text{(Equation 4)}$$

which represent all possible harmonics **(step 305)**. However, due to the high system frequencies involved, examination of frequencies beyond the 10th harmonic is unnecessary.

The existence of an interfering ODBF is determined by serially calculating the differences between two harmonics of the second **49** and **51** third PLL synthesizers that are separated by at least one degree until the absolute value of an *ODBFm,n* is within a given bandwidth or a predetermined number of *ODBFm,n* values are calculated. When an *ODBFm,n* absolute value is found within the RF channel bandwidth, it is designated as an interfering oscillator difference beat frequency (ODBF). The general equation for calculating ODBFs is:

$$OBDF_{m,n} = (m + n)\ (LO2)\text{-}(m)(LO3),\ for\ m = 1, 2, 3, 4, \ldots 10, \qquad \text{(Equation 5)}$$

with $n$ = 1 for a first series, $n$ = 2 for a second series, $n$ = 3 for a third series, and so on up to $n$ = 8 for all previously calculated harmonics **(step 305)**. The $ODBF_{m,n}$ calculated from the differing degrees of the second **49** and third PLL **51** harmonics are then examined **(step 307)**. For example, if the ODBF lies outside of the desired RF output channel bandwidth, no adjustment of the second **49** and third **51** PLL frequency synthesizers is required.

For an ODBF which falls inband, the following equations can be used to determine which direction the second **49** and third **51** PLL frequencies should be adjusted to translate the ODBF out of band. In these equations, CLB is the channel low-band; CMB is the channel mid-band; and CHB is the channel high-band.

If -CHB≤ODBF<-CMB; then HI-IF is moved downward. (Equation 6A)

(If the result of **Equation 5** is negative and the magnitude is greater than the mid-band of the desired RF output channel **(step 309**), the HI-IF is moved downward **(step 311)**).

If -CMB≤ODBF≤-CLB; then HI-IF is moved upward. (Equation 6B)

(If the result of **Equation 5** is negative and the magnitude is less than or equal to the mid-band of the desired RF output channel **(step 313)**, the HI-IF is moved upward **(step 315)**).

If CLB≤ODBF≤CMB; then HI-IF is moved downward. (Equation 6C)

(If the result of **Equation 5** is positive and the magnitude is less or equal to than the mid-band of the desired RF output channel **(step 317)**, the HI-IF is moved downward **(step 319)**).

If CMB<ODBF≤CHB; then HI-IF is moved upward. (Equation 6D)

(If the result of **Equation 5** is positive and the magnitude is greater than the mid-band of the desired RF output channel **(step 321),** the HI-IF is moved upward **(step 323)**).
The second **49** and third **51** PLLs are then adjusted **(step 327)** in accordance with the following: To translate the oscillator difference beats below or above the desired RF output channel, the following equation is used to determine the Δ in frequency for the second **49** and third **51** PLL frequency synthesizers.

$$\Delta = \frac{CMB - [(m+n)(LO2) - m(LO3)]}{(m+n) - m} \quad \text{(Equation 7)}$$

The new second **49** and third **51** PLL frequencies (LO2' and LO3' respectively) are derived as shown in LO2' is calculated as shown in **Figure 6.**

The new PLL frequencies LO2' and LO3' translate the ODBFs above or below the desired RF output channel. The new PLL frequency values are used to program the second **49** and third **51** PLL frequency synthesizers **(step 327).**

The present invention will now be explained with reference to several examples. For simplicity, these examples will use a nominal valve of Δ = 4 MHz. In the first example, if the HI-IF is 960 MHz and the desired RF output channel . has a picture carrier frequency of 319.25 MHz, we have the following:

LO2 = HI-IF = 960 MHz; (from Equation 2)

and

LO3 = HI-IF + RF output

= 960 + 319.25 = 1279.25 MHz. (from Equation 3)

The graph for ODBFs versus the RF output frequencies for m=2 and n=1 is shown in **Figure 9A**. If m=2 and n=1, then:

$$ODBF_{2,1}(960) = (m+n)\ (LO2)\ -m(LO3)$$

$$= 3(960)-2(1279.25)$$

$$= 2880-2558.5 = 321.5\text{ MHz} \qquad \text{(from Equation 5)}$$

Since the desired RF output channel has a picture carrier frequency of 319.25 MHz (and assuming the bandwidth is 6 MHz for an NTSC channel), the ODBF is in-band for the desired RF output channel. From **Equation 6D**, since the ODBF is above the mid-band of the desired RF output channel; the HI-IF is moved upward. Assuming that Δ has a value of 4 MHz, LO2' will be 964 MHz and LO3' will be 1283.25 MHz. Accordingly, from **Equation 5:**

$$ODBF_{2,1}(964) = 3(964)-2(964+319.25)$$

$$= 2892-2566.5 = 325.5\text{ MHz}$$

The ODBF is now out of band.

In the second example, if the HI-IF is 960 MHz and the desired RF output channel has a picture carrier frequency of 481.25 MHz, we then have the following:

$$LO2 = HI\text{-}IF = 960\text{ MHz}; \qquad \text{(from Equation 2)}$$

and

$$LO3 = HI\text{-}IF + RF\text{ output}$$

$$= 960 + 481.25 = 1441.25\text{ MHz}. \qquad \text{(from Equation 3)}$$

The graph for ODBFs versus the RF output frequencies for m=3 and n=1 is shown in **Figure 9B**. If m=3 and n=1, the ODBF can be calculated as:

$$ODBF_{3,1}(960) = 4\ (960)-3\ (1441.25)$$

$$= 3840-4323.75$$

$$= -483.75\text{MHz}. \qquad \text{(from Equation 5)}$$

Since the selected channel is 481.25 MHz, (and assuming an NTSC channel), the ODBF is in-band and the HI-IF must be relocated. The result of **Equation 5** for this example is negative and the magnitude is greater than the mid-band of the desired RF output channel (481.25 MHz). Accordingly, from **Equation 6A**, the HI-IF is moved lower. Assuming that Δ has a value of 4 MHz, LO2' will be 956 MHz and LO3' will be 1437.25 MHz. Recalculating the ODBF provides:

$$ODBF_{3,1}(956) = 4\ (956)-3(956+481.25)$$

$$= 3824-4311.75 = -487.75\text{ MHz}. \qquad \text{(from Equation 5)}$$

The ODBF is now out of band.

Due to the simple design of the present invention and since there are no shielding requirements to avoid ODBFs, the universal modulator may be incorporated onto a single integrated circuit. This was not possible with prior art signs.

Although the present invention has been described with reference to a settop terminal, it should be understood by those of skill in the art that the invention is adaptable to other applications within the CATV environment, or even other communication applications which do not pertain to CATV systems.

For example, as shown in **Figure 7**, a prior art headend **700** generally includes two pieces of equipment; a baseband section **702** and an IF section **704**. These two sections **702**, **704** are typically designed to operate as "stand alone" units. Together, the two sections **702, 704** output a single RF channel. The baseband section **702** generally comprises a video section **706** and an audio section **708**. These sections **706, 708** receive audio and video baseband inputs and combine these inputs to an intermediate frequency for output to the IF section **704.** In the IF section **704**, the intermediate frequency is up-converted to the desired RF output channel. Since both sections **702, 704** comprise units of equipment which are designed to work independently, this requires the duplication of many components between units **702, 704**.

Referring to **Figure 8,** a headend **800** made in accordance with the present invention is shown. The headend **800** includes an audio pre-processing section **802,** a video pre-processing section **804,** the universal modulator **808** of the present invention (which is coupled to two filters **810, 812**), a transmitter **814** (if desired), and a microprocessor **806,** which controls all of the components of the headend **800.** As was previously described hereinbefore, since the universal modulator **808** can convert a baseband input signal to any desired RF output signal while avoiding ODBFs, the universal modulator **808** may be utilized to replace most of the components in the baseband section **702** and the IF section **704**. This significantly reduces the number of components required for a headend **800**. Accordingly, the cost and complexity are also thereby reduced.

It should be understood by those of skill in the art, with reference to **Figure 8**, that the universal modulator **808** of the present invention may also be used to accept a baseband digital VSB signal and remodulate the signal to a desired RF output signal for use with broadcast HDTV television receivers. The universal modulator **808** could also be used to transmit RF signals to devices which require high frequency RF signals, including wireless appliances such as a cordless telephone or a wireless LAN receiver. In such an application, the second mixer up-converts the HI-IF signal to a higher frequency RF signal, instead of down-converting the HI-IF as previously described. The desired RF output signal would be:

$$\text{RF output} = (\text{HI-IF})+\text{LO3} \qquad \text{(Equation 10)}$$

The RF output signal may then be transmitted directly to the wireless appliance.

## Claims

1. A communication module which receives an input RF signal and converts said input RF signal to a desired RF output channel signal (105) having a bandwidth **characterised by** a channel low-band frequency, a channel mid-band frequency and a channel high-band frequency, the communication module comprising:

    a first frequency agile local oscillator (49) for generating a first frequency for mixing with said input RF signal to generate a high intermediate frequency signal;
    a second frequency agile local oscillator (51) for generating a second frequency for mixing with said high intermediate frequency signal to generate said desired RF output channel signal (105);
    a processor including:

        a controller for controlling said first and second frequency agile local oscillators (49,51) to obtain said desired RF output channel signal (105); and

    a comparator for comparing said first frequency with said second frequency to determine if at least one interfering oscillator difference beat frequency exists within the bandwidth of said desired RF output channel signal (105), and to calculate a delta value using said channel mid-band-frequency and said first and second frequencies to avoid said interfering oscillator difference beat frequency; whereby said processor adjusts said first (49) and second (51) frequency agile local oscillators by said delta value such that said first and second frequencies move said interfering oscillator difference beat frequency above or below the bandwidth of said desired RF output channel signal (105) determined by comparing said interfering oscillator beat frequency to said channel mid-band frequency and either said channel low-band frequency or said channel high band frequency.

2. The communication module of claim 1 wherein the communication module receives a plurality of input RF signals and said communication module further includes a signal selector for selecting one of said plurality of input RF signals for mixing with said first frequency.

**3.** The communication module of claim 1 or claim 2, further comprising a transmitter for wirelessly transmitting said RF output channel signal to a receiver.

**4.** The communication module of claim 3, wherein said transmitted signal is transmitted within the UHF or VHF frequency bands.

**5.** The communication module of any preceding claim, wherein the communication module is encompassed within a single integrated circuit.

**6.** The communication module of any preceding claim, wherein the communication module comprises an RF receiver circuit.

**7.** The communication module of any preceding claim wherein said selected signal represents an analog signal transmission.

**8.** The communication module of claim 2, wherein said selected signal represents an analog signal transmission.

**9.** The communication module of claim 2, wherein said selected signal represents a digital signal transmission.

**10.** The communication module of any preceding claim, wherein said controller further comprises:

collateral memory storing a channel map of channels to predetermined channel carrier frequencies;
means for receiving a specific channel selection request to said microprocessor; and
said microprocessor determines said initial first local oscillator frequency.

**11.** A universal modulator which receives a plurality of baseband input signals and outputs a desired RF output channel signal (105) having a bandwidth **characterised by** a channel low-band frequency, a channel mid-band frequency and a channel high-band frequency, the universal modulator comprising:

a first PLL frequency synthesiser (41) for generating a first PLL frequency for mixing with a baseband audio signal to relocate said baseband audio signal within a desired bandwidth;
a second PLL frequency synthesiser (49) for generating a second PLL frequency for mixing with a summed signal which includes said relocated baseband audio signal and a baseband video signal to produce a high intermediate frequency signal;
a third PLL frequency synthesiser (51) for generating a third PLL frequency for mixing with said high intermediate frequency signal to produce said RF output channel signal (102); and
a processor for controlling said first (41), second (49) and third (51) PLL frequency synthesisers based upon said desired RF output channel signal whereby said processor:

determines a first PLL frequency for said first synthesiser (41),

determines said second PLL frequency for said second synthesiser (49),
compares said second PLL frequency with said third PLL frequency for said third synthesiser (51) to determine if at least one interfering oscillator difference beat frequency exists within the bandwidth of said desired RF output channel signal (105) and to calculate a delta value using said channel mid-band frequency and said second and third PLL frequencies to avoid said interfering oscillator difference beat frequency; and
adjusts said second and third PLL frequencies by said delta value to move any said interfering oscillator difference beat frequency above or below the bandwidth of said RF output channel signal (105) determined by comparing said interfering oscillator beat frequency to said channel mid-band frequency and either said channel low-band frequency or said channel high-band frequency.

**12.** A method for receiving an input RF signal and converting said input RF signal to a desired RF output channel signal (105) having a bandwidth **characterised by** a channel low-band frequency, a channel mid-band frequency and a channel high-band frequency, the method comprising:

generating a first frequency for mixing with said input RF signal to generate a high intermediate frequency signal;
generating a second frequency for mixing with said high intermediate frequency signal to generate said desired RF output channel signal;
controlling said first and second frequencies to obtain said desired RF output channel signal;
comparing said first frequency with said second frequency to determine if at least one interfering oscillator difference beat frequency exists within the bandwidth of the desired RF output channel signal, and to calculate a delta value using said channel mid-band frequency and first and second frequencies to avoid said interfering oscillator difference beat frequency; and
adjusting said first and second frequencies by said delta value such that said first and second frequencies move said interfering oscillator difference beat frequency above or below the bandwidth of said desired RF output channel signal determined by comparing said interfering oscillator beat frequency to said channel mid-band frequency and either said channel low-band frequency or said channel high-band frequency.

**Patentansprüche**

**1.** Ein Kommunikationsmodul, das ein RF-Eingangssignal empfängt und das RF-Eingangssignal in ein gewünschtes RF-Ausgabekanalsignal (105) umwandelt, dessen Bandbreite durch eine Kanal-Unterbandfrequenz, eine Kanal-Bandmittenfrequenz und eine Kahal-Oberbandfrequenz **gekennzeichnet** ist, wobei das Kommunikationsmodul Folgendes beinhaltet:

einen agilen Lokaloszillator (49) mit erster Frequenz zum Erzeugen einer ersten Frequenz zur Mischung mit dem RF-Eingangssignal, um ein hohes Zwischenfrequenzsignal zu erzeugen;

einen agilen Lokaloszillator (51) mit zweiter Frequenz zum Erzeugen einer zweiten Frequenz zur Mischung mit dem hohen Zwischenfrequenzsignal, um das gewünschte RF-Ausgabekanalsignal (105) zu erzeugen;

einen Prozessor, der Folgendes umfasst:

einen Regler zum Regeln der agilen Lokaloszillatoren (49, 51) mit erster und zweiter Frequenz, um das gewünschte RF-Ausgabekanalsignal (105) zu erhalten; und

einen Komparator zum Vergleichen der ersten Frequenz mit der zweiten Frequenz, um zu bestimmen, ob mindestens eine störende Schwebungsfrequenz des Oszillatorunterschieds innerhalb der Bandbreite des gewünschten RF-Ausgabekanalsignals (105) vorhanden ist, und um einen Delta-Wert unter Verwendung der Kanal-Bandmittenfrequenz und der ersten und zweiten Frequenz zu berechnen, um die störende Schwebungsfrequenz des Oszillatorunterschieds zu vermeiden; wobei der Prozessor die agilen Lokaloszillatoren mit erster (49) und zweiter (51) Frequenz, um den Delta-Wert anpasst, so dass die erste und zweite Frequenz die störende Schwebungsfrequenz des Oszillatorunterschieds oberhalb oder unterhalb der Bandbreite des gewünschten RF-Ausgabekanalsignals (105), die durch das Vergleichen der störenden Schwebungsfrequenz des Oszillatorunterschieds mit der Kanal-Bandmittenfrequenz und entweder der Kanal-Unterbandfrequenz oder der Kanal-Oberbandfrequenz bestimmt wird, bewegt.

**2.** Kommunikationsmodul gemäß Anspruch 1, wobei das Kommunikationsmodul eine Vielzahl von RF-Eingangssignalen empfängt und das Kommunikationsmodul ferner einen Signalwähler zum Wählen eines der Vielzahl von RF-Eingangssignalen zur Mischung mit der ersten Frequenz umfasst.

**3.** Kommunikationsmodul gemäß Anspruch 1 oder Anspruch 2, das ferner einen Sender zum drahtlosen Übertragen des RF-Ausgabekanalsignals an einen Empfänger beinhaltet.

**4.** Kommunikationsmodul gemäß Anspruch 3, wobei das übertragene Signal innerhalb der UHF- oder VHF-Frequenzbänder übertragen wird.

**5.** Kommunikationsmodul gemäß einem der vorhergehenden Ansprüche, wobei das Kommunikationsmodul von einer einzelnen integrierten Schaltung umgeben ist.

**6.** Kommunikationsmodul gemäß einem der vorhergehenden Ansprüche, wobei das Kommunikationsmodul eine RF-Empfängerschaltung beinhaltet.

**7.** Kommunikationsmodul gemäß einem der vorhergehenden Ansprüche, wobei das gewählte Signal eine analoge Signalübertragung darstellt.

**8.** Kommunikationsmodul gemäß Anspruch 2, wobei das gewählte Signal eine analoge Signalübertragung darstellt.

**9.** Kommunikationsmodul gemäß Anspruch 2, wobei das gewählte Signal eine digitale Signalübertragung darstellt.

**10.** Kommunikationsmodul gemäß einem der vorhergehenden Ansprüche, wobei der Regler ferner Folgendes beinhaltet:

zusätzlichen Speicher, der ein Kanal-Speicherabbild der Kanäle speichert, um die Kanal-Trägerfrequenzen vorherzubestimmen;

Mittel zum Empfangen einer spezifischen Kanal-Auswahlabfrage an den Mikroprozessor; und

wobei der Mikroprozessor die anfängliche erste Lokaloszillator-Frequenz bestimmt.

**11.** Ein Universalmodulator, der eine Vielzahl von Basisband-Eingangssignalen empfängt und ein gewünschtes RF-Ausgabekanalsignal (105), dessen Bandbreite durch eine Kanal-Unterbandfrequenz, eine Kanal-Bandmittenfrequenz und eine Kanal-Oberbandfrequenz **gekennzeichnet** ist, wobei der Universalmodulator Folgendes beinhaltet:

einen ersten PLL-Frequenzsynthesizer (41) zum Erzeugen einer ersten PLL-Frequenz zur Mischung mit einem Basisband-Audiosignal, um das Basisband-Audiosignal innerhalb einer gewünschten Bandbreite zu verschieben;

einen zweiten PLL-Frequenzsynthesizer (49) zum Erzeugen einer zweiten PLL-Frequenz zur Mischung mit einem Summensignal, das das verschobene Basisband-Audiosignal und ein Basisband-Videosignal umfasst, um ein hohes Zwischen frequenz signal zu produzieren;

einen dritten PLL-Frequenzsynthesizer (51) zum Erzeugen einer dritten PLL-Frequenz zur Mischung mit dem hohen Zwischenfrequenzsignal, um das RF-Ausgabekanalsignal (102) zu produzieren; und

einen Prozessor zum Regeln des ersten (41), zweiten (49) und dritten (51) PLL-Frequenzsynthesizers, die auf dem gewünschten RF-Ausgabekanalsignal basieren, wobei der Prozessor:

eine erste PLL-Frequenz für den ersten Synthesizer (41) bestimmt,

die zweite PLL-Frequenz für den zweiten Synthesizer (49) bestimmt,

die zweite PLL-Frequenz mit der dritten PLL-Frequenz für den dritten Synthesizer (51) vergleicht, um zu bestimmen, ob mindestens eine störende Schwebungsfrequenz des Oszillatorunterschieds innerhalb der Bandbreite des ersten gewünschten RF-Ausgabekanalsignals (105) vorhanden ist, und um einen Delta-Wert unter Verwendung der Kanal-Bandmittenfrequenz und der zweiten und dritten PLL-Frequenz zu berechnen, um die störende Schwebungsfrequenz des Oszillatorunterschieds zu vermeiden; und

die zweite und dritte PLL-Frequenz um den Delta-Wert angepasst, um jede störende Schwebungsfrequenz des Oszillatorunterschieds oberhalb oder unterhalb der Bandbreite des RF-Ausgabekanalsignals (105), die durch das Vergleichen der störenden Schwebungsfrequenz des Oszillatorunterschieds mit der Kanal-Bandmittenfrequenz und entweder der Kanal-Unterbandfrequenz oder der Kanal-Oberbandfrequenz bestimmt wird, zu bewegen.

**12.** Ein Verfahren zum Empfangen eines RF-Eingangssignals und Umwandeln des RF-Eingangssignals in ein gewünschtes RF-Ausgabekanalsignal (105) dessen Bandbreite durch eine Kanal-Unterbandfrequenz, eine Kanal-Bandmittenfrequenz und eine Kanal-Oberbandfrequenz **gekennzeichnet** ist, wobei das Verfahren Folgendes beinhaltet:

Erzeugen einer ersten Frequenz zur Mischung mit dem RF-Eingangssignal, um eine hohes Zwischenfrequenzsignal zu erzeugen;

Erzeugen einer zweiten Frequenz zur Mischung mit dem hohen Zwischenfrequenzsignal, um das gewünschte RF-Ausgabekanalsignal zu erzeugen;

Regeln der ersten und zweiten Frequenz, um das gewünschte RF-Ausgabekanalsignal zu erhalten;

Vergleichen der ersten Frequenz mit der zweiten Frequenz, um zu bestimmen, ob mindestens eine störende Schwebungsfrequenz des Oszillatorunterschieds innerhalb der Bandbreite des gewünschten RF-Ausgabekanalsignals vorhanden ist, und um einen Delta-Wert unter Verwendung der Kanal-Bandmittenfrequenz und der ersten und zweiten Frequenz zu berechen, um die störende Schwebungsfrequenz des Oszillatorunterschieds zu vermeiden; und

Anpassen der ersten und zweiten Frequenz um den Delta-Wert, so dass die erste und zweite Frequenz die störende Schwebungsfrequenz des Oszillatorunterschieds oberhalb oder unterhalb der Bandbreite des RF-Ausgabekanalsignals, die durch das Vergleichen der störenden Schwebungsfrequenz des Oszillatorunterschieds mit der Kanal-Bandmittenfrequenz und entweder der Kanal-Unterbandfrequenz oder der Kanal-Oberbandfrequenz bestimmt wird, bewegt.

**Revendications**

1. Un module de communication qui reçoit un signal RF d'entrée et convertit ledit signal RF d'entrée en un signal de canal de sortie RF souhaité (105) ayant une largeur de bande **caractérisée par** une fréquence de bande basse de canal, une fréquence centrale de canal et une fréquence de bande haute de canal, le module de communication comportant :

   un premier oscillateur local agile en fréquence (49) pour générer une première fréquence destinée à être mélangée avec ledit signal RF d'entrée pour générer un signal de fréquence haute intermédiaire ;

   un deuxième oscillateur local agile en fréquence (51) pour générer une deuxième fréquence destinée à être mélangée avec ledit signal de fréquence haute intermédiaire pour générer ledit signal de canal de sortie RF souhaité (105) ;

   un processeur comprenant :

      un contrôleur destiné à contrôler lesdits premier et deuxième oscillateurs locaux agiles en fréquence (49, 51) afin d'obtenir ledit signal de canal de sortie RF souhaité (105) ; et

   un comparateur destiné à comparer ladite première fréquence à ladite deuxième fréquence afin de déterminer si une fréquence de battement différentielle d'oscillateurs interférante au moins existe au sein de la largeur de bande dudit signal de canal de sortie RF souhaité (105), et de calculer une valeur delta en utilisant ladite fréquence centrale de canal et lesdites première et deuxième fréquences afin d'éviter ladite fréquence de battement différentielle d'oscillateurs interférante ; grâce à quoi ledit processeur ajuste lesdits premier (49) et deuxième (51) oscillateurs locaux agiles en fréquence de ladite valeur delta de telle sorte que lesdites première et deuxième fréquences déplacent ladite fréquence de battement différentielle d'oscillateurs interférante au-dessus ou au-dessous de la largeur de bande dudit signal de canal de sortie RF souhaité (105) déterminée en comparant ladite fréquence de battement d'oscillateurs interférante à ladite fréquence centrale de canal et à l'une ou l'autre de ladite fréquence de bande basse de canal ou de ladite fréquence de bande haute de canal.

2. Le module de communication de la revendication 1 dans lequel le module de communication reçoit une pluralité de signaux RF d'entrée et ledit module de communication comprend de plus un sélecteur de signal pour sélectionner un signal parmi ladite pluralité de signaux RF d'entrée destiné à être mélangé avec ladite première fréquence.

3. Le module de communication de la revendication 1 ou de la revendication 2, comportant de plus un transmetteur destiné à transmettre sans fil ledit signal de canal de sortie RF à un récepteur.

4. Le module de communication de la revendication 3, dans lequel ledit signal transmis est transmis au sein des bandes de fréquences UHF ou THF.

5. Le module de communication de n'importe quelle revendication précédente, dans lequel le module de communication est englobé à l'intérieur d'un circuit intégré unique.

6. Le module de communication de n'importe quelle revendication précédente, dans lequel le module de communication comporte un circuit récepteur RF.

7. Le module de communication de n'importe quelle revendication précédente dans lequel ledit signal sélectionné représente une transmission de signal analogique.

8. Le module de communication de la revendication 2, dans lequel ledit signal sélectionné représente une transmission de signal analogique.

9. Le module de communication de la revendication 2, dans lequel ledit signal sélectionné représente une transmission de signal numérique.

10. Le module de communication de n'importe quelle revendication précédente, dans lequel ledit contrôleur comporte de plus :

    une mémoire collatérale stockant une carte de canaux des canaux à des fréquences porteuses de canal prédéterminées ;

    un moyen destiné à recevoir une requête de sélection de canal spécifique auprès dudit microprocesseur ; et

    ledit microprocesseur détermine ladite fréquence de premier oscillateur local initiale.

11. Un modulateur universel qui reçoit une pluralité de signaux d'entrée en bande de base et sort un signal de canal de sortie RF souhaité (105) ayant une largeur de bande **caractérisée par** une fréquence de bande basse de canal, une fréquence centrale de canal et une fréquence de bande haute de canal, le modulateur universel comportant :

    un premier synthétiseur de fréquences PLL (41) pour générer une première fréquence PLL destinée à être mélangée avec un signal audio en bande de base afin de translater ledit signal audio en bande de base à l'intérieur d'une largeur de bande souhaitée ;

    un deuxième synthétiseur de fréquences PLL (49) pour générer une deuxième fréquence PLL destinée à être mélangée avec un signal additionné qui comprend ledit signal audio en bande de base translaté et un signal vidéo en bande de base afin de produire un signal de fréquence haute intermédiaire ;

    un troisième synthétiseur de fréquences PLL (51) pour générer une troisième fréquence PLL destinée à être mélangée avec ledit signal de fréquence haute intermédiaire afin de produire ledit signal de canal de sortie RF (102) ; et

    un processeur destiné à contrôler lesdits premier (41), deuxième (49) et troisième (51) synthétiseurs de fréquences PLL sur la base dudit signal de canal de sortie RF souhaité grâce à quoi ledit processeur :

        détermine une première fréquence PLL pour ledit premier synthétiseur (41),

        détermine ladite deuxième fréquence PLL pour ledit deuxième synthétiseur (49),

        compare ladite deuxième fréquence PLL à ladite troisième fréquence PLL pour ledit troisième synthétiseur (51) afin de déterminer si une fréquence de battement différentielle d'oscillateurs interférante au moins existe au sein de la largeur de bande dudit signal de canal de sortie RF souhaité (105) et de calculer une valeur delta en utilisant ladite fréquence centrale de canal et lesdites deuxième et troisième fréquences PLL afin d'éviter ladite fréquence de battement différentielle d'oscillateurs interférante ; et

        ajuste lesdites deuxième et troisième fréquences PLL de ladite valeur delta afin de déplacer n'importe quelle dite fréquence de battement différentielle d'oscillateurs interférante au-dessus ou au-dessous de la largeur de bande dudit signal de canal de sortie RF (105) déterminée en comparant ladite fréquence de battement d'oscillateurs interférante à ladite fréquence centrale de canal et à l'une ou l'autre de ladite fréquence de bande basse de canal ou de ladite fréquence de bande haute de canal.

**12.** Un procédé destiné à recevoir un signal RF d'entrée et à convertir ledit signal RF d'entrée en un signal de canal de sortie RF souhaité (105) ayant une largeur de bande **caractérisée par** une fréquence de bande basse de canal, une fréquence centrale de canal et une fréquence de bande haute de canal, le procédé comportant :

générer une première fréquence destinée à être mélangée avec ledit signal RF d'entrée afin de générer un signal de fréquence haute intermédiaire ;

générer une deuxième fréquence destinée à être mélangée avec ledit signal de fréquence haute intermédiaire afin de générer ledit signal de canal de sortie RF souhaité ;

contrôler lesdites première et deuxième fréquences afin d'obtenir ledit signal de canal de sortie RF souhaité ;

comparer ladite première fréquence à ladite deuxième fréquence afin de déterminer si une fréquence de battement différentielle d'oscillateurs interférante au moins existe au sein de la largeur de bande du signal de canal de sortie RF souhaité, et de calculer une valeur delta en utilisant ladite fréquence centrale de canal et lesdites première et deuxième fréquences afin d'éviter ladite fréquence de battement différentielle d'oscillateurs interférante ; et

ajuster lesdites première et deuxième fréquences de ladite valeur delta de telle sorte que lesdites première et deuxième fréquences déplacent ladite fréquence de battement différentielle d'oscillateurs interférante au-dessus ou au-dessous de la largeur de bande dudit signal de canal de sortie RF souhaité déterminée en comparant ladite fréquence de battement d'oscillateurs interférante à ladite fréquence centrale de canal et à l'une ou l'autre de ladite fréquence de bande basse de canal ou de ladite fréquence de bande haute de canal.

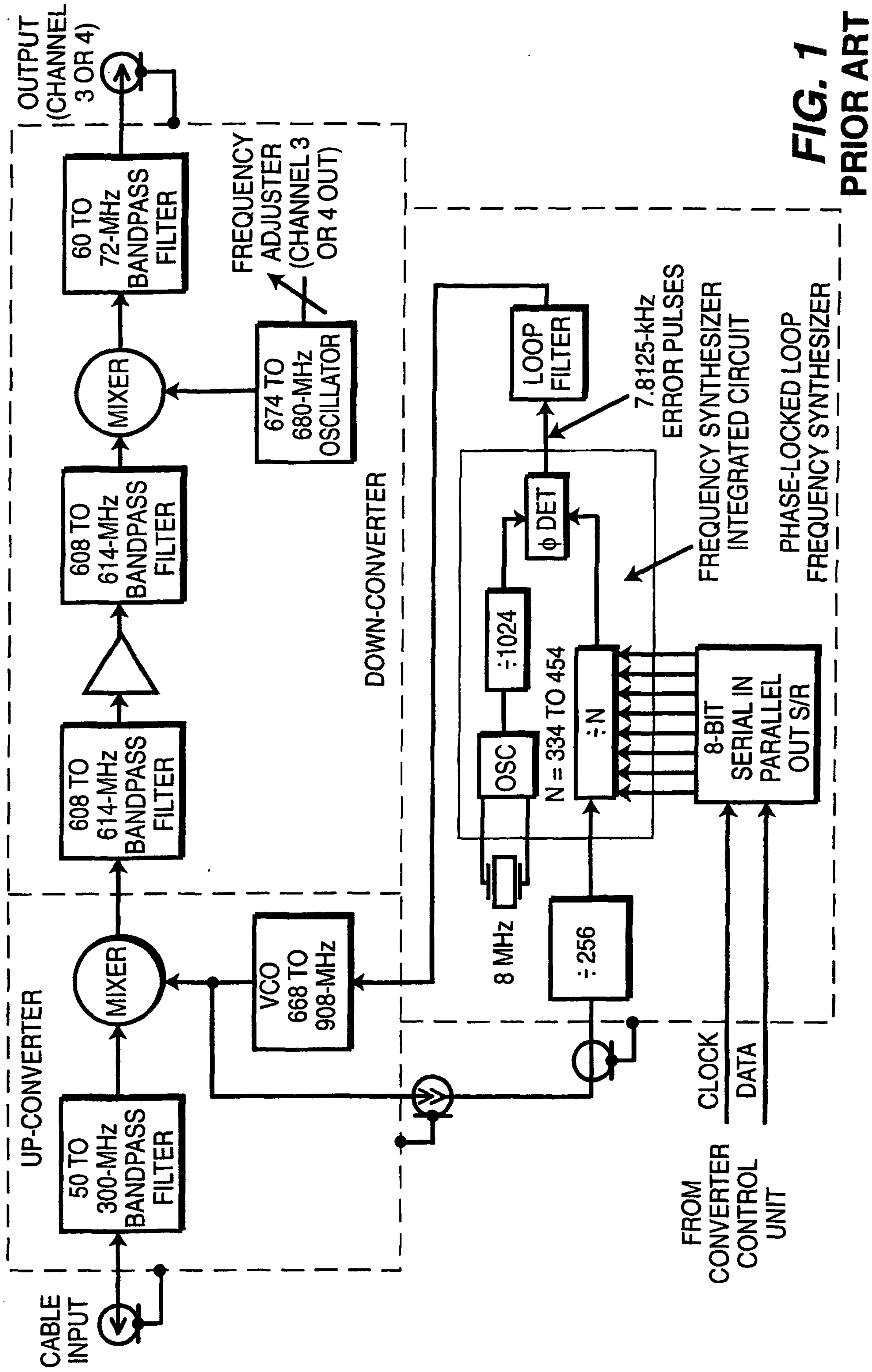


FIG. 1
PRIOR ART

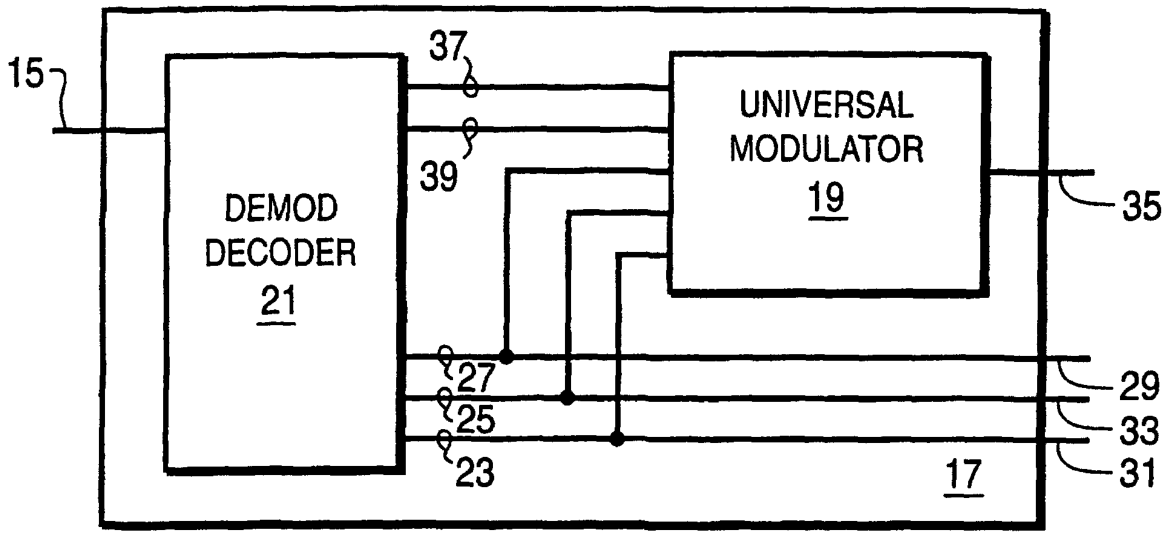
15
37
39
DEMOD
DECODER
21
UNIVERSAL
MODULATOR
19
35
27
25
23
29
33
31
17

FIG. 2

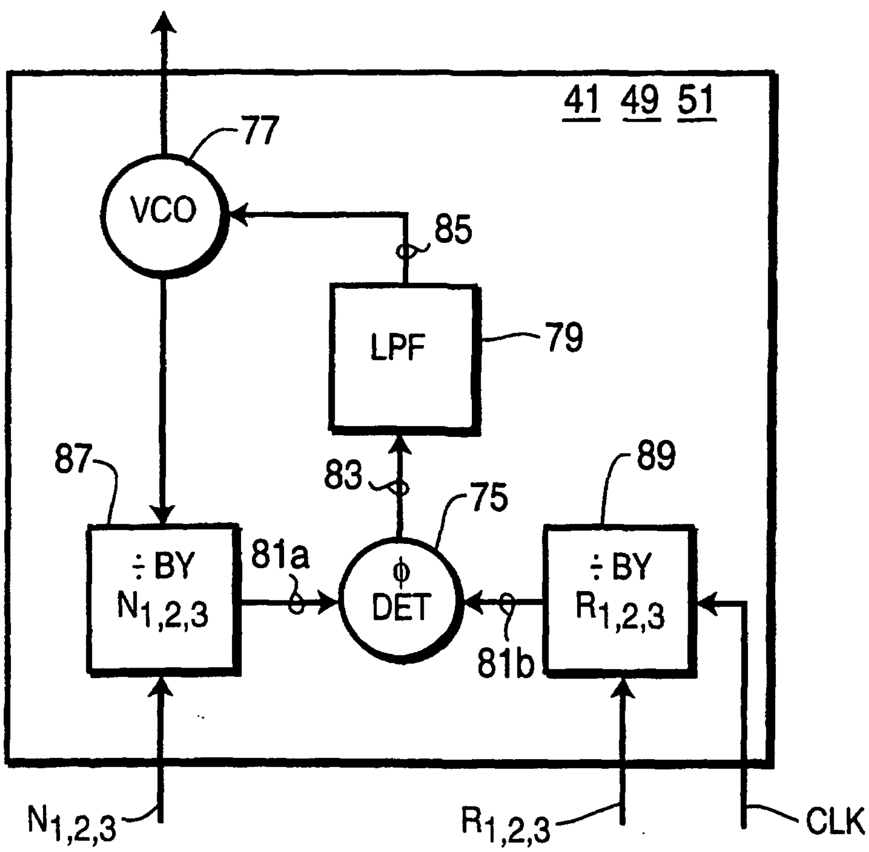
41 49 51
77
VCO
85
LPF
79
87
83
75
89
÷ BY
N1,2,3
81a
ϕ
DET
÷ BY
R1,2,3
81b
N1,2,3
R1,2,3
CLK

FIG. 4

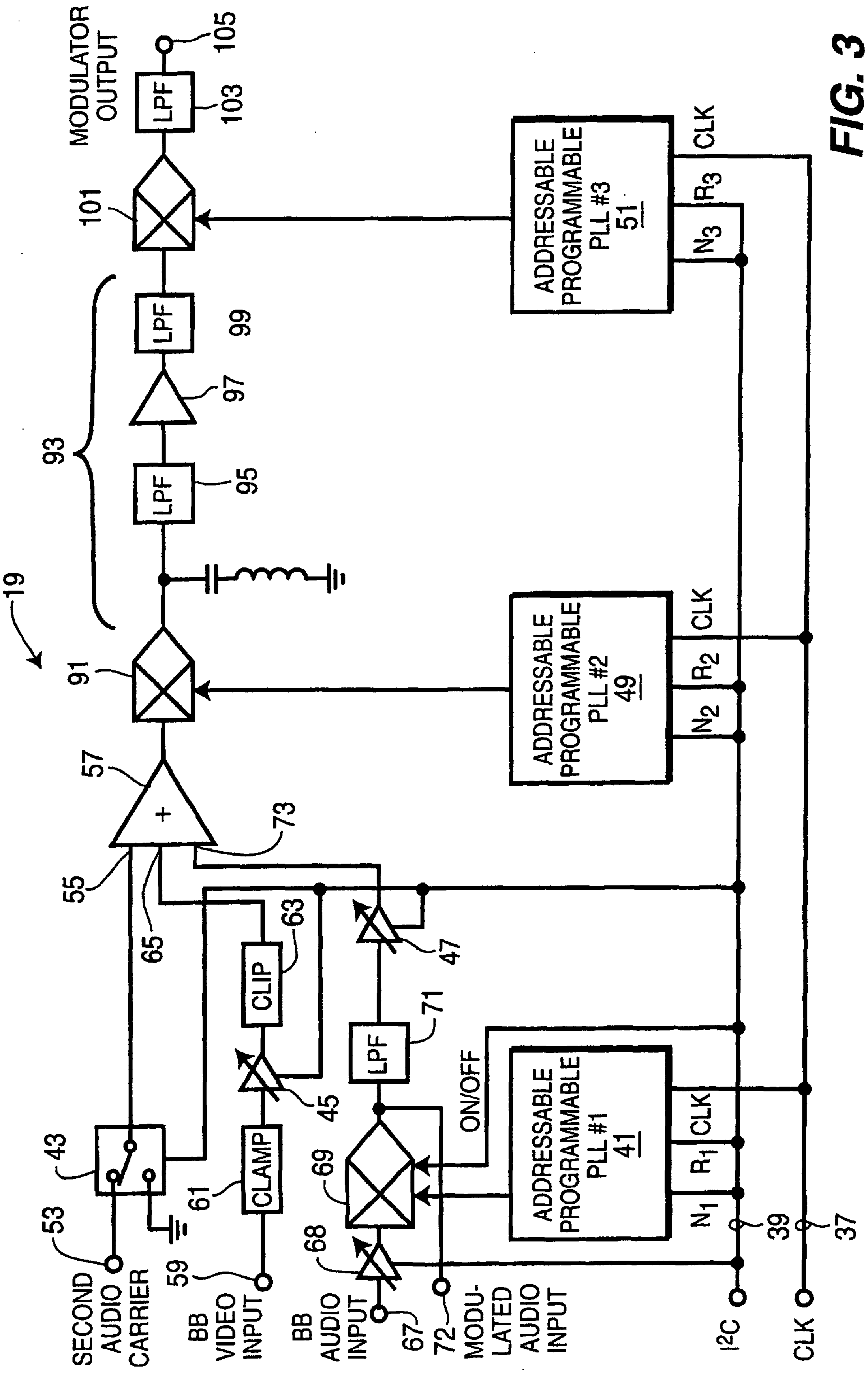
MODULATOR OUTPUT
105
LPF
103
101
99
LPF
97
93
95
LPF
19
91
57
+
73
55
65
63
CLIP
47
71
LPF
ON/OFF
45
43
CLAMP
61
53
SECOND AUDIO CARRIER
59
BB VIDEO INPUT
68
69
BB AUDIO INPUT
67
72
MODU-LATED AUDIO INPUT
I2C
CLK
ADDRESSABLE PROGRAMMABLE PLL #1 41
N1
R1
CLK
39
37
ADDRESSABLE PROGRAMMABLE PLL #2 49
N2
R2
CLK
ADDRESSABLE PROGRAMMABLE PLL #3 51
N3
R3
CLK

FIG. 3

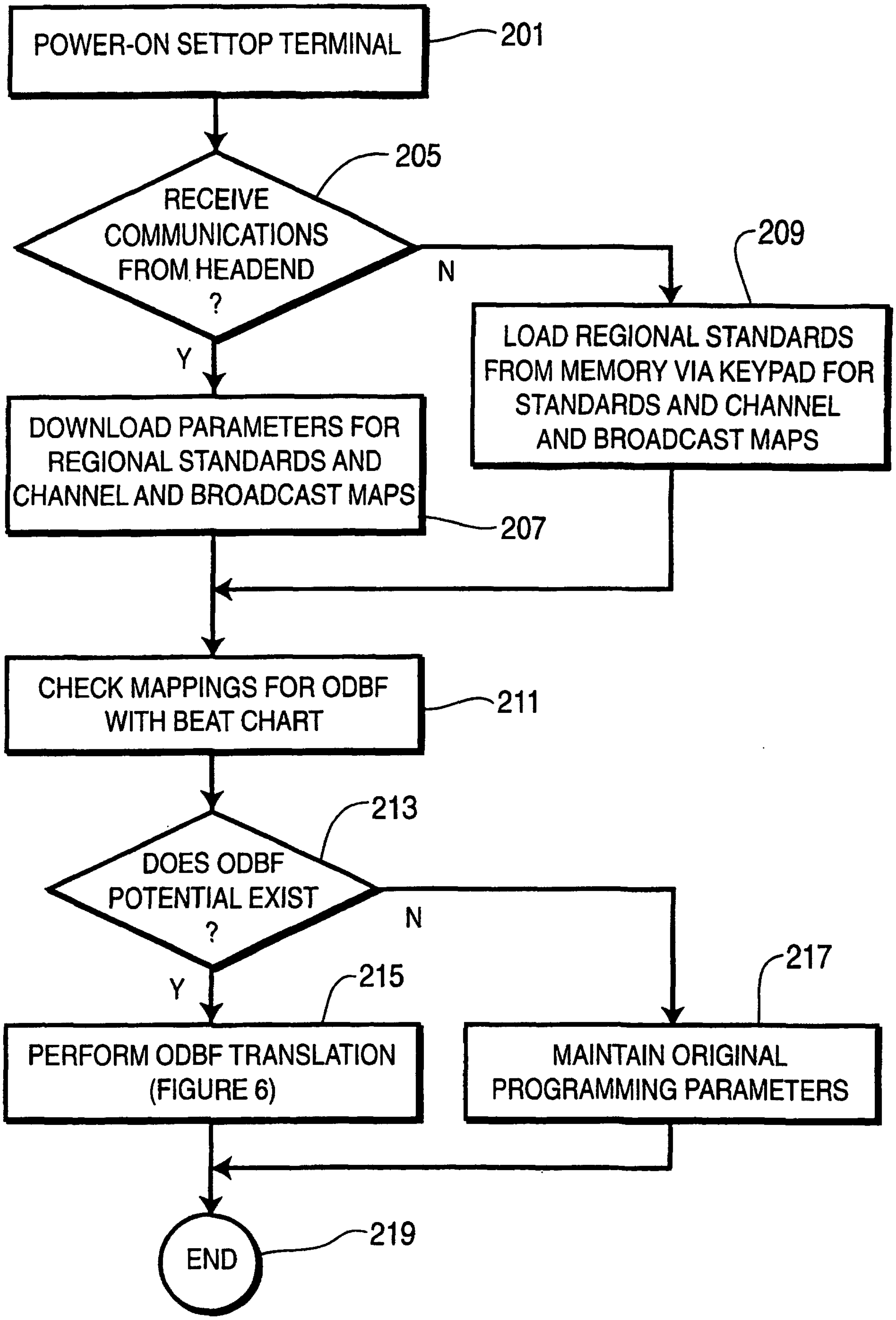
POWER-ON SETTOP TERMINAL
201
RECEIVE COMMUNICATIONS FROM HEADEND ?
205
N
209
LOAD REGIONAL STANDARDS FROM MEMORY VIA KEYPAD FOR STANDARDS AND CHANNEL AND BROADCAST MAPS
Y
DOWNLOAD PARAMETERS FOR REGIONAL STANDARDS AND CHANNEL AND BROADCAST MAPS
207
CHECK MAPPINGS FOR ODBF WITH BEAT CHART
211
213
DOES ODBF POTENTIAL EXIST ?
N
217
Y
215
PERFORM ODBF TRANSLATION (FIGURE 6)
MAINTAIN ORIGINAL PROGRAMMING PARAMETERS
END
219

*FIG. 5*

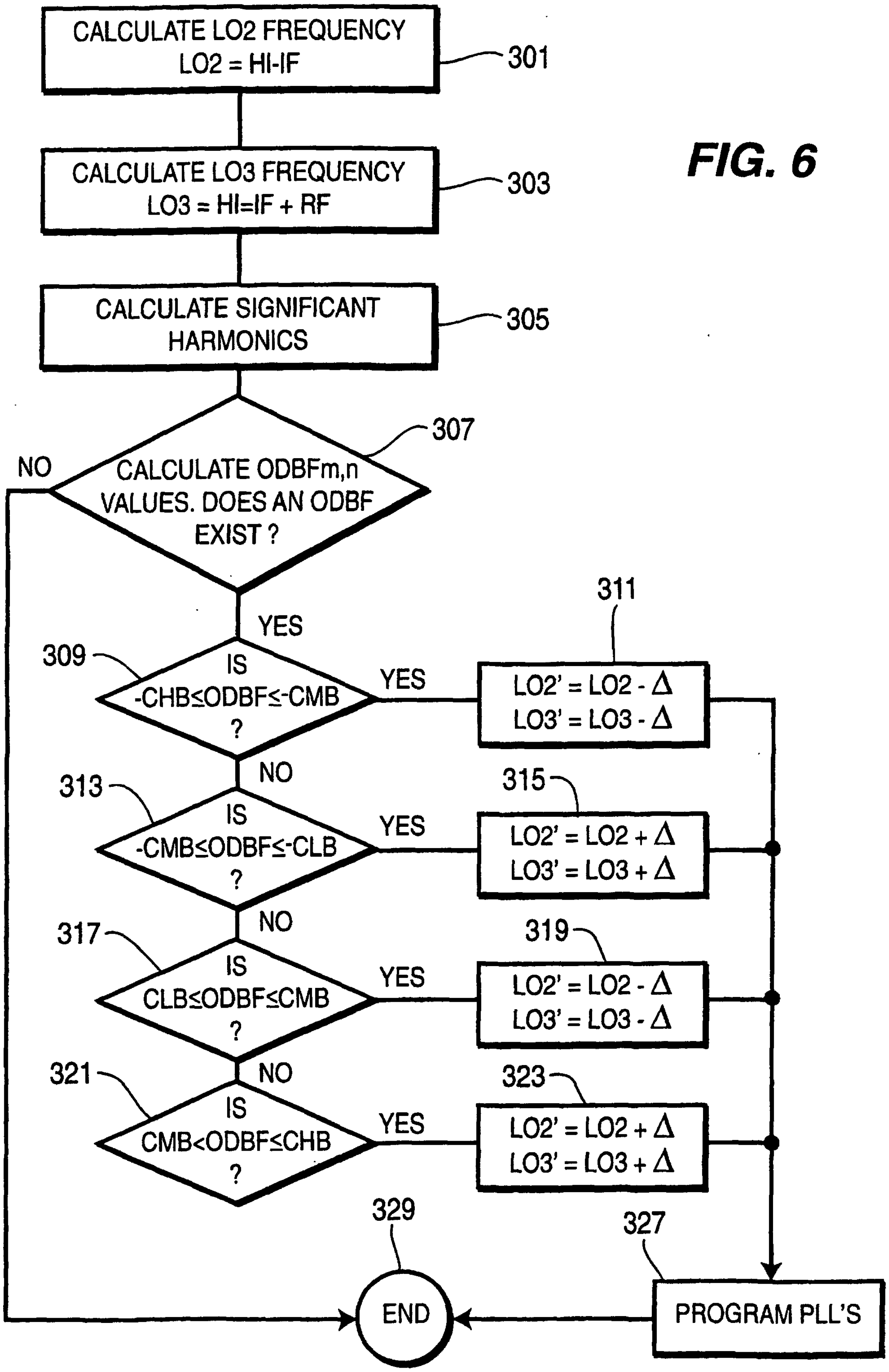
CALCULATE LO2 FREQUENCY
LO2 = HI-IF
301
CALCULATE LO3 FREQUENCY
LO3 = HI=IF + RF
303
CALCULATE SIGNIFICANT HARMONICS
305
CALCULATE ODBFm,n VALUES. DOES AN ODBF EXIST ?
307
NO
YES
309
IS -CHB≤ODBF≤-CMB ?
YES
311
LO2' = LO2 - Δ
LO3' = LO3 - Δ
NO
313
IS -CMB≤ODBF≤-CLB ?
YES
315
LO2' = LO2 + Δ
LO3' = LO3 + Δ
NO
317
IS CLB≤ODBF≤CMB ?
YES
319
LO2' = LO2 - Δ
LO3' = LO3 - Δ
NO
321
IS CMB<ODBF≤CHB ?
YES
323
LO2' = LO2 + Δ
LO3' = LO3 + Δ
329
END
327
PROGRAM PLL'S

FIG. 6

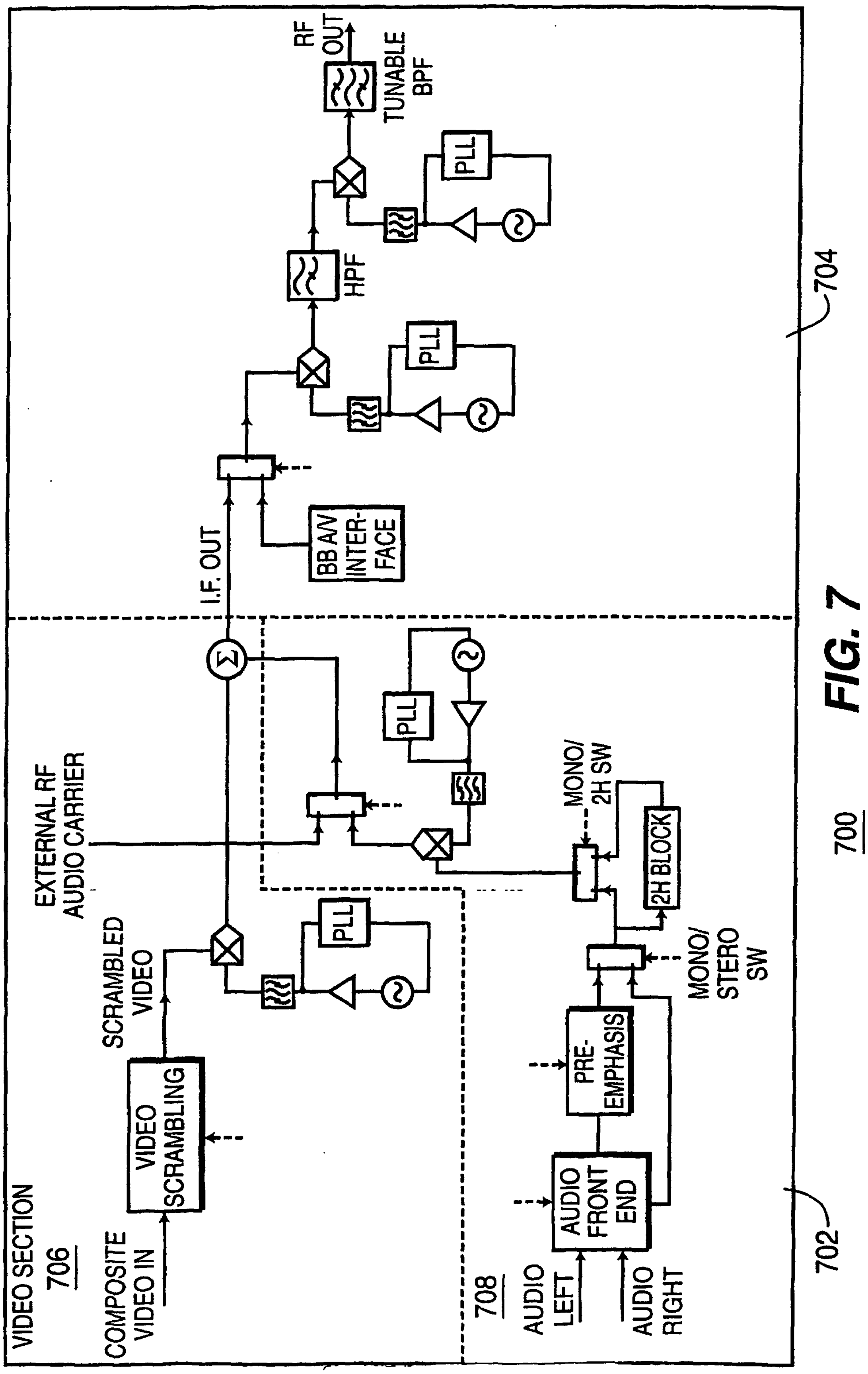


*FIG. 7*
**PRIOR ART**

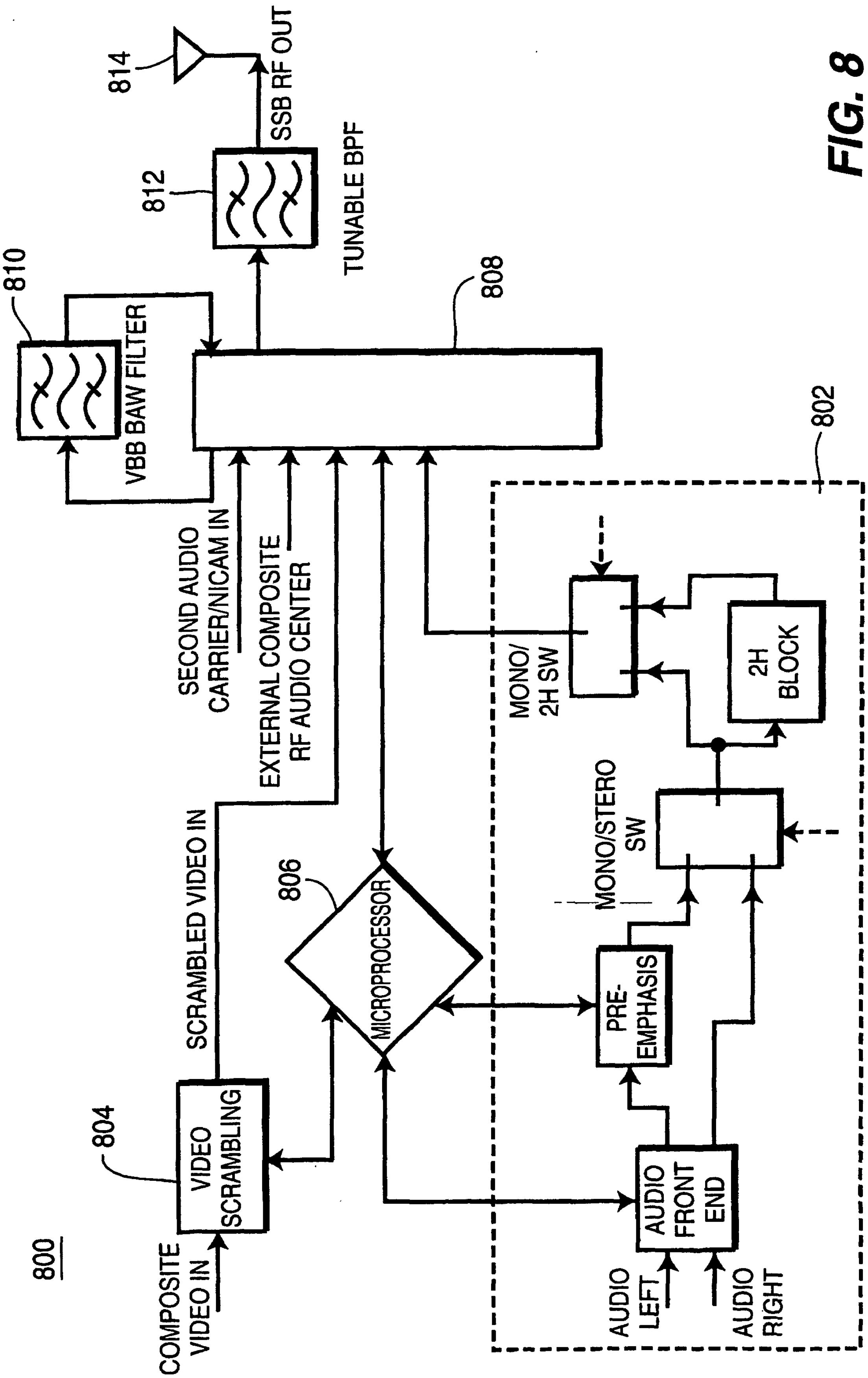
800
COMPOSITE VIDEO IN
804
VIDEO SCRAMBLING
SCRAMBLED VIDEO IN
806
MICROPROCESSOR
EXTERNAL COMPOSITE RF AUDIO CENTER
SECOND AUDIO CARRIER/NICAM IN
VBB BAW FILTER
810
808
812
TUNABLE BPF
SSB RF OUT
814
802
AUDIO LEFT
AUDIO RIGHT
AUDIO FRONT END
PRE-EMPHASIS
MONO
MONO/STERO SW
2H BLOCK
MONO/ 2H SW

FIG. 8

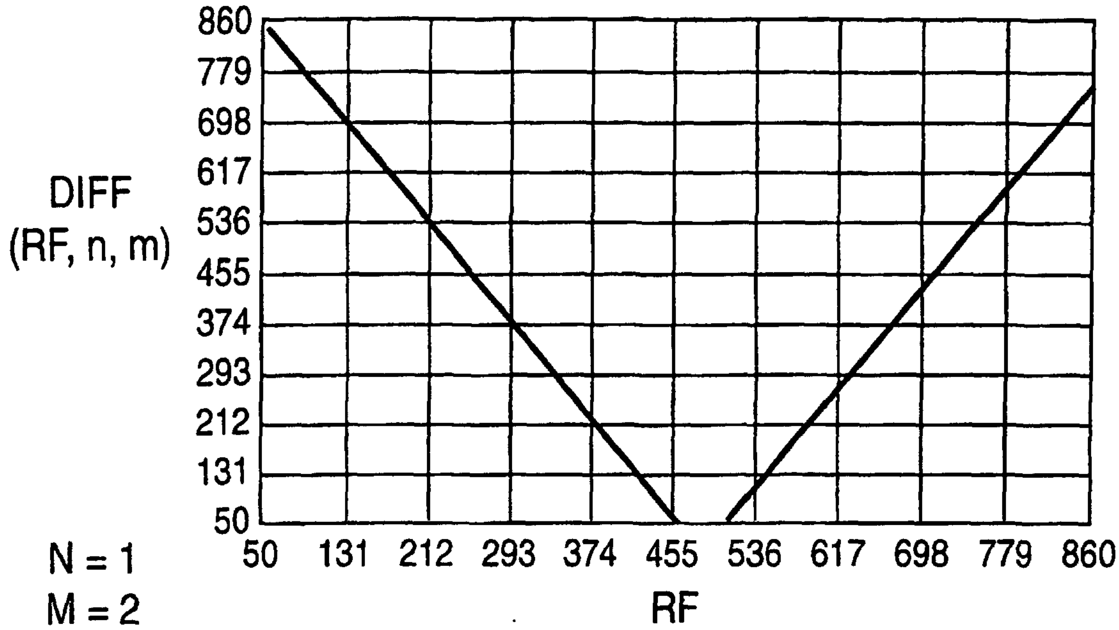
860
779
698
617
536
455
374
293
212
131
50
DIFF
(RF, n, m)
N = 1
M = 2
50 131 212 293 374 455 536 617 698 779 860
RF

*FIG. 9A*

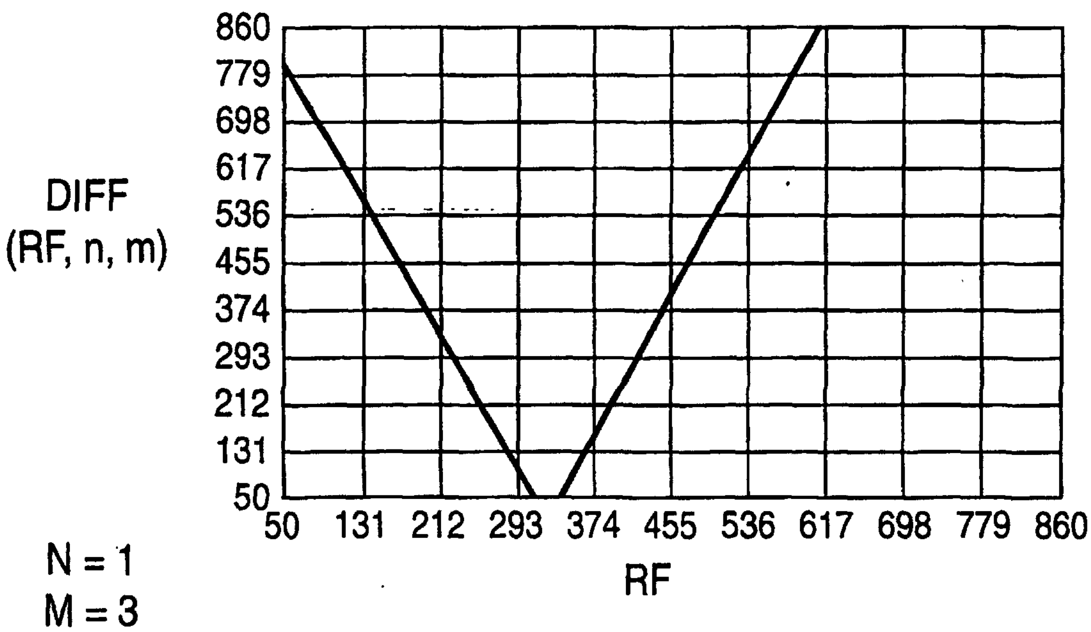
860
779
698
617
536
455
374
293
212
131
50
DIFF
(RF, n, m)
N = 1
M = 3
50 131 212 293 374 455 536 617 698 779 860
RF

*FIG. 9B*